# EUROPÄISCHE PATENTSCHRIFT

(11) **EP 2 920 667 B1**
(45) Veröffentlichungstag und Bekanntmachung des Hinweises auf die Patenterteilung: **19.04.2017**
(21) Anmeldenummer: 13777232.3
(22) Anmeldetag: 07.10.2013
(51) Int. Cl.: G06F 1/16

(54) **SCHUTZEINRICHTUNG FÜR EIN BEDIENGERÄT**
PROTECTIVE EQUIPMENT FOR A CONTROLLER
DISPOSITIF DE PROTECTION POUR UN BOÎTIER DE COMMANDE

(30) Priorität: 13.11.2012 DE 102012220693
(43) Veröffentlichungstag der Anmeldung: 23.09.2015
(73) Patentinhaber: TRUMPF Medizin Systeme GmbH + Co. KG, 07318 Saalfeld (DE)
(72) Erfinder: MARKA, Rudolf, 85737 Ismaning (DE); ÖZHAN, Serhan, 81379 München (DE)
(74) Vertreter: Prüfer & Partner mbB Patentanwälte · Rechtsanwälte
(86) Internationale Anmeldenummer: PCT/EP2013/003012
(87) Internationale Veröffentlichungsnummer: WO 2014/075750

(56) Entgegenhaltungen:
- EP-A1- 2 180 773
- DE-A1-102008 020 968
- US-A- 5 812 188
- US-A- 6 082 535
- US-A1- 2002 195 910
- US-A1- 2007 247 793

## Beschreibung

Die Erfindung betrifft eine Schutzeinrichtung für ein Bediengerät, insbesondere eine Schutzeinrichtung für ein Bediengerät, das einen Touchscreen aufweist.

Es sind Schutzhüllen für ein Bediengerät mit einem Touchscreen bekannt, die das Bediengerät vollständig umschließen, um das Bediengerät vor Spritzwasser zu schützen. Das Patent US 7,495,895 B2 zeigt beispielsweise eine Schutzabdeckung, die im Bereich des Touchscreens eine dünne flexible Membran aufweist, durch die hindurch der Touchscreen bedient wird.

Weiterhin zeigt die Druckschrift WO 98/02170 ein Schutzhülle, die über einen Monitor gezogen wird, um ihn in einem sterilen Bereich betreiben zu können.

Dabei besteht jedoch das Problem, dass das Bediengerät dadurch nicht gegen Schäden geschützt ist, die durch einen Herunterfallen hervorgerufen werden. Die Schutzabdeckung ist zudem aufwändig zu sterilisieren und bei der Verwendung der Schutzhülle, die als Einmalartikel verwendet werden kann, kann diese verrutschen, so dass die Bedienung des Touchscreens nicht mehr störungsfrei gewährleistet ist. Außerdem ist es erforderlich, dass die Schutzhülle eine Öffnung aufweist, durch die das Bediengerät in die Schutzhülle eingeführt werden kann, die wiederum spritzwassergeschützt verschließbar sein muss.

Druckschrift EP 2 180 773 A1 offenbart eine tragbare elektronische Einrichtung mit einem sterilisierbaren Gehäuse, das aus einem elastischen Material besteht, das sterilisierbar ist, mit einem Überhang auf einer Vorderseite des Bediengeräts. Das Gehäuse ist so geformt, dass es das Bediengerät umschließt, eine innere Fläche ist so geformt, dass sie im Wesentlichen an eine Rückseite des Bediengeräts angepasst ist, und die Aussparung hat eine Form und ein Größe, so dass zumindest eine Fläche eines Touchscreens des Bediengeräts ausgespart ist.

US 2002/0195910 A1 zeigt eine transparente abdichtbare Schutzfolie für elektronische Touchscreens, wobei ein Unterteil davon so geformt ist, dass eine Innenseite davon an Bereiche von Seiten und einer Rückseite des Bediengeräts angepasst ist. Ein Gehäuseoberteil ist transparent und so elastisch, dass eine Betätigung des Gehäuseoberteils auf den Touchscreen möglich ist, und das Gehäuseunterteil und ein Gehäuseoberteil flüssigkeitsdicht verbunden sind.

Der Erfindung liegt die Aufgabe zugrunde, eine Schutzeinrichtung für ein Bediengerät zur Verwendung in einer sterilen Umgebung bereitzustellen, die einfach, sicher und kostengünstig ist, und die eine Bedienung des Touchscreens nicht beeinträchtigt.

Die Aufgabe wird durch ein Schutzsystem gemäß Anspruch 1 gelöst. Weiterentwicklungen des Schutzsystems sind Gegenstand der abhängigen Ansprüche.

Durch die Verwendung eines Stoßschutzrahmens, der sterilisierbar ist, ist das Bediengerät in einem sterilen Bereich einsetzbar und auch dort bei einem Herunterfallen gegen Schäden geschützt.

Durch die Ausbildung einer Schutzhülle so, dass sie das Bediengerät umschließt, wobei zumindest eine Fläche des Touchscreens ausgespart wird, ist es möglich, kommerziell verfügbare Bediengeräte mit Touchscreen, wie etwa Tablet-Computer, in einer Umgebung, in der eine Sprüh- oder Wischdesinfektion erforderlich ist, zu verwenden.

Durch ein Schutzsystem mit dem sterilisierbaren Stoßschutzrahmen, der sterilisierbaren Folienhülle und der Schutzhülle, wird ein weitergehender Schutz gegen Beschädigungen und eine verbesserte Sterilität gegenüber den vorbenannten Lösungen erreicht.

Die Schutzhülle ist ebenfalls sterilisierbar ausführbar.

Die Erfindung wird nun anhand von Ausführungsbeispielen unter Bezugnahme auf die beigefügten Zeichnungen erläutert.

Insbesondere zeigen:
- Fig. 1: eine Explosionszeichnung eines Schutzsystems mit optionalen Bauteilen;
- Fig. 2: ein Bediengerät mit einem Touchscreen mit einer Schutzhülle;
- Fig. 3: das Bediengerät von Fig. 2 mit einem Stoßschutzrahmen;
- Fig. 4: eine Querschnittsdarstellung eines Schutzgehäuses; und
- Fig. 5: eine Querschnittsdarstellung des Schutzsystems aus dem Schutzgehäuse und dem Stoßschutzrahmen.

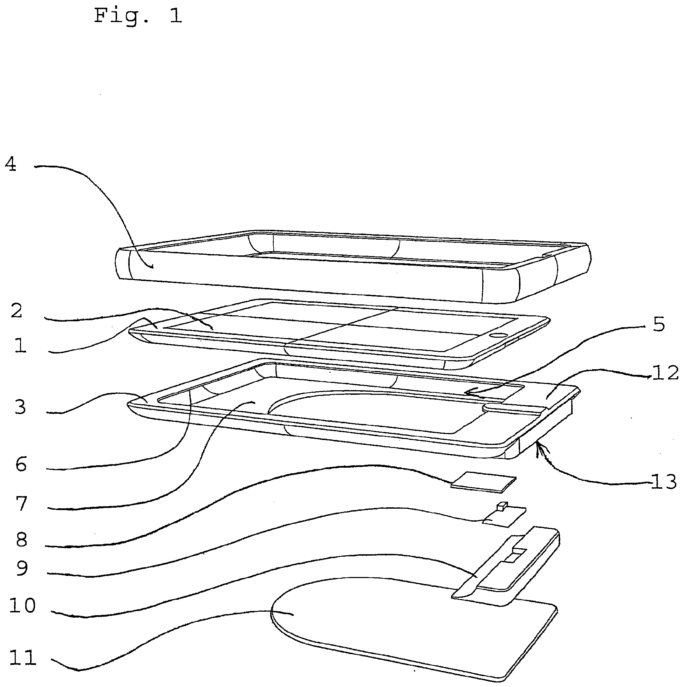

In Fig. 1 ist ein Schutzsystem zum Schützen eines Bediengeräts 1 mit einem Touchscreen 2 gezeigt. Der Touchscreen 2 des Bediengeräts 1 ist nicht zwingend erforderlich. Alternativ sind auch andere Bedienelemente, beispielsweise abgedichtete Schalter oder Schalter einer Folientastatur möglich. Wesentlich ist, dass kein Eindringen von verspritzten Flüssigkeiten zwischen einem Gehäuse des Bediengeräts und den Bedienelementen möglich ist.

Das Schutzsystem weist einen Stoßschutzrahmen 4, optional eine Schutzhülle 3, und optional eine später beschriebene Folienhülle auf.

Die Schutzhülle 3 ist schalenartig geformt und umschließt das Bediengerät 1 zumindest an den Seiten sowie an der Rückseite schalenförmig. Die Schutzhülle 3 weist eine Oberseite 12 und eine Unterseite 13 auf. Zudem weist die Schutzhülle 3 eine Aussparung 5, die ein Volumen des Bediengeräts 1 ausspart, mit einer inneren Fläche 7 auf, die im Wesentlichen an eine Rückseite des Bediengeräts 1 angepasst ist. Die Aussparung weist auf der Oberseite 12 eine Öffnung mit einem Rand 6 auf.

Die Aussparung 5 ist so in der Schutzhülle 3 vorgesehen, dass sie zumindest eine Fläche des Touchscreens 2 ausspart. An dem Rand 6 der Aussparung 5 bildet die Schutzhülle 3 mit dem Bediengerät 1 einen flüssigkeitsdichten Übergang, wie im Folgenden genauer erläutert wird.

Die Oberseite 12 weist zur Aussparung 5 hin einen Überhang über das Bediengerät 1 in Richtung der Aussparung 5 auf. Der Überhang ist so geformt, dass er in Richtung der Unterseite 13 zeigt. Der Rand 6 ist also näher an der inneren Fläche 7 angeordnet als ein verbleibender Bereich des Überhangs. Dadurch liegt nach einer Montage des Bediengeräts 1 in der Schutzhülle 3 der Rand 6 auf der Außenfläche des Bediengeräts 1 mit einer Vorspannung auf, wodurch der flüssigkeitsdichte Übergang gebildet wird.

Alternativ weist die Schutzhülle 3 an dem Rand 6 eine zu der inneren Fläche 7 hin vorstehende Rippe auf. Dadurch kann ebenfalls gewährleistet werden, dass die Schutzhülle 3 mit einer Vorspannung am Rand 6 auf der Außenfläche des Bediengeräts 1 aufliegt und der flüssigkeitsdichte Übergang gebildet wird.

In weiteren Alternativen sind eine Kombination der vorgenannten Maßnahmen oder beispielsweise ein Vorsehen von weiteren Dichtlippen oder anderen Dichtungsmaßnahmen möglich.

Durch die Schutzhülle 3 sind außerhalb einer Umgebung des Touchscreens 2 alle Bereiche des Bediengeräts abgedeckt.

Alternativ können weitere Aussparungen in der Schutzhülle 3 vorgesehen sein, die dann jeweils mit einem Verschluss flüssigkeitsdicht verschlossen sind.

Die Schutzhülle 3 ist aus Silikon hergestellt, kann aber alternativ auch aus anderen geeigneten elastischen Materialien hergestellt sein. Entscheidend ist, dass die Schutzhülle 3 nach der Montage des Bediengeräts 1 dieses umschließt, die Aussparung 5 zumindest die vollständige Fläche des Touchscreens 2 ausspart und der Rand 6 mit einer ausreichenden Vorspannung an der Außenfläche des Bediengeräts 1 abdichtend aufliegt. Die elastische Schutzhülle 3 ermöglicht einen Schutzhüllenaustausch durch den Benutzer. Alternativ kann die Schutzhülle 3 auch formstabil ausgeführt werden. In diesem Fall kann vorgesehen sein, dass die Schutzhülle 3 nicht bzw. nur von eingewiesenem Servicepersonal entfernt werden kann.

Zur Verbesserung des Schutzes besteht die Möglichkeit, den Stoßschutzrahmen 4 an der Schutzhülle 3 anzubringen, um das Bediengerät noch sicherer vor Beschädigungen, beispielsweise bei einem Fallen auf den Boden, zu schützen. Dazu weist der Stoßschutzrahmen 4 an einem Innenumfang eine Kontur auf, die komplementär zu einer Kontur einer umlaufenden Kante der Schutzhülle 3 geformt ist.

Der Stoßschutzrahmen 4 besteht aus Silikon und ist sterilisierbar oder alternativ aus einem anderen geeigneten sterilisierbaren Material. Der Stoßschutzrahmen 4 ist so geformt, dass er auf einer Vorderseite und einer Rückseite der Schutzhülle 3 einen Überhang bildet, so dass der Stoßschutzrahmen 4 das Bediengerät 1 umschließt, um sicher an der Schutzhülle 3 montierbar zu sein.

Alternativ ist der Stoßschutzrahmen 4 so geformt, dass er das Bediengerät 1 umschließt und auf einer Vorderseite und einer Rückseite des Bediengeräts 1 einen Überhang bildet.

Bei der Verwendung der nicht gezeigten Folienhülle, in die das in der Schutzhülle 3 befindliche Bediengerät 1 einbringbar ist, ist es günstig, den Stoßschutzrahmen 4 über der Folienhülle anzubringen, so dass eine sichere Befestigung der Folienhülle auf der Schutzhülle 3 gewährleistet werden kann, indem die Folienhülle zwischen dem Stoßschutzrahmen 4 und der Schutzhülle 3 eingeklemmt wird.

Die Folienhülle ist tütenförmig (alternativ: schlauchförmig oder ein Folienabschnitt) und weist eine Größe auf, so dass sie das Bediengerät 1, ggf. in der Schutzhülle 3, vollständig umschließt. Die Folienhülle ist sterilisierbar.

Die innen liegende Kontur des Stoßschutzrahmens 4 und die dazu komplementär umlaufende Kante der Schutzhülle 3 oder das Bediengerät 1 und die innere Kontur des Stoßschutzrahmens 4 sind in ihren Abmessungen so aufeinander abgestimmt, dass die Folienhülle dazwischen eingeklemmt werden kann. Dadurch ist es möglich, die Folienhülle über dem Touchscreen 2 straff zu halten, so dass dessen Bedienung störungsfrei möglich ist.

In einer optionalen Ausführungsform ist die Schutzhülle 3 mit einer Induktionsspule 8 versehen. Die Induktionsspule 8 ist über eine elektronische Steuerungseinrichtung 10 auf einer Platine 11 mit dem Bediengerät 1 verbunden und ermöglicht ein kontaktloses Aufladen eines Akkumulators des Bediengeräts 1. Dazu wird die Induktionsspule 8 in die Nähe einer weiteren nicht gezeigten Spule gebracht und über eine Induktivität die elektrische Energie kontaktlos zu dem Bediengerät 1 übertragen, ohne dass eine Aussparung in der Schutzhülle 3 erforderlich ist.

In einer weiteren alternativen Ausführungsform ist die Schutzhülle 3 zusätzlich oder alternativ mit einem Funksender und -empfänger versehen. Über den Funksender und -empfänger ist eine Ortung des Bediengeräts 1 möglich. Dadurch besteht die Möglichkeit, die räumliche Lage des Bediengeräts 1 zu den zu bedienenden Geräten zu erkennen und/oder die Anzeige des Touchscreen entsprechend anzupassen.

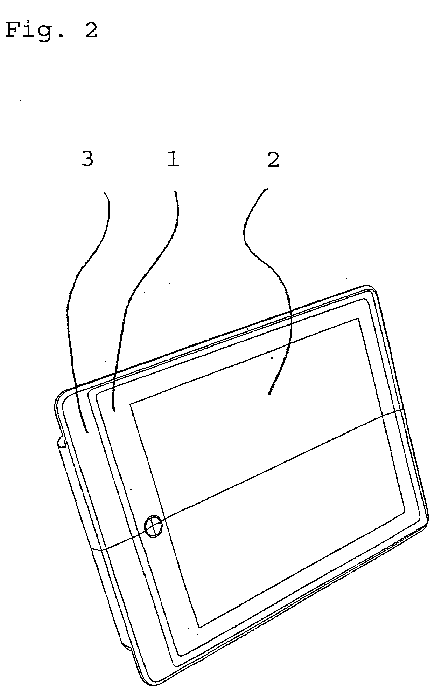

Fig. 2 zeigt das Bediengerät 1 mit dem Touchscreen 2 mit der Schutzhülle 3.

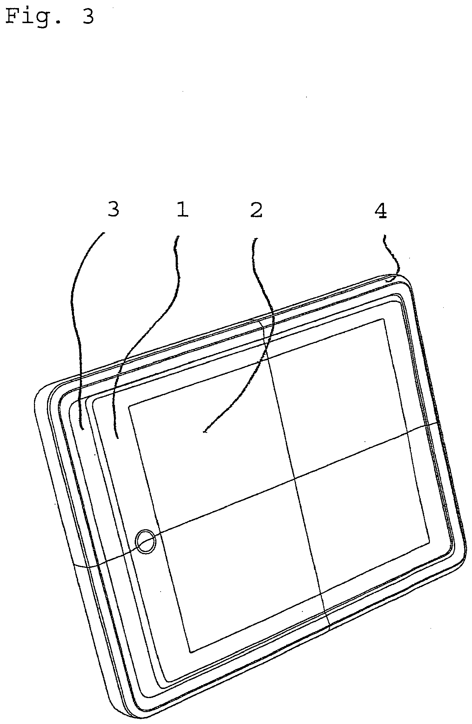

Fig. 3 ist eine Darstellung des Bediengeräts 1 mit der Schutzhülle 3 von Fig. 2, die zusätzlich mit dem Stoßschutzrahmen 4 versehen ist.

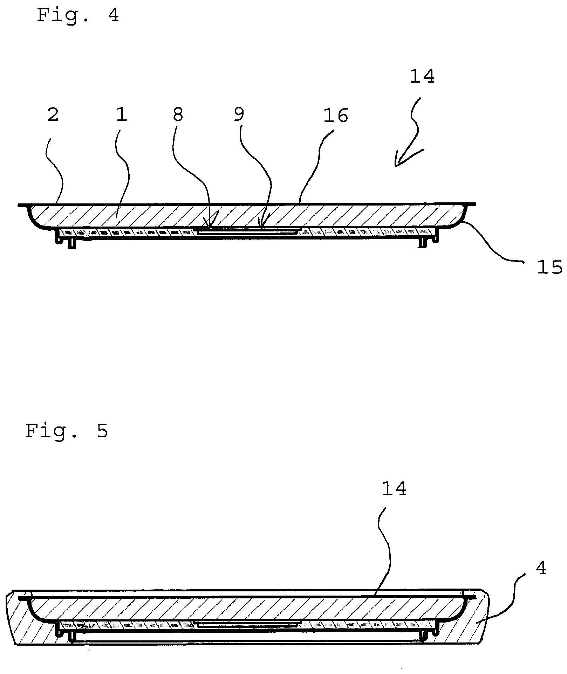

In Fig. 4 ist eine Querschnittsdarstellung eines Schutzgehäuses 14 gezeigt. Das Schutzgehäuse 14 weist ein Gehäuseunterteil 15 und ein Gehäuseoberteil 16 auf.

Das Gehäuseunterteil 15 ist ein Formteil aus einem plattenförmigen Kunststoffausgangsmaterial. Alternativ ist es in einem Spritzgussverfahren oder ähnlichem hergestellt. In einer weiteren Alternative kann auch ein ausreichend flexibles Material, wie beispielsweise eine Folie, Verwendung finden, die eine ausreichende Formanpassung an die Bedieneinheit bei Verbindung mit dem Gehäuseoberteil 16 erlaubt. Es weist eine Innenseite auf und wird fertigungstechnisch in eine Form gebracht, so dass die Innenseite an Bereiche von den Seiten und der Rückseite des Bediengeräts 1 so angepasst ist, dass eine relative Bewegung des Bediengeräts 1 in dem Schutzgehäuse 14 begrenzt wird. Das Gehäuseunterteil 15 ist nicht genau an das Bediengerät 1 angepasst, da ansonsten dadurch ein Einbringen von zusätzlichen Bauteilen oder Baugruppen nicht möglich wäre, und die Verwendung auch für ähnliche Bediengeräte nicht sicher gestellt ist. Alternativ kann auch eine genaue Anpassung vorgesehen sein. Durch die Formgebung wird die Steifigkeit des Gehäuseunterteils 15 gegenüber dem Ausgangsmaterial erhöht, so dass es formstabil ist, also seine Form beibehält, wenn keine äußeren Kräfte darauf einwirken. Optional ist das Gehäuseunterteil 15 aus einem Material hergestellt, das eine Steifigkeit und eine Wandstärke aufweist, so dass das Gehäuseunterteil 15 unelastisch ist, also nur mit einem großen Kraftaufwand geringfügig verformt werden kann. Dies stellt einen zusätzlichen Schutz gegen Beschädigungen des Bediengeräts 1 dar. Das Gehäuseunterteil 15 weist ferner eine umlaufende Fläche auf, an der das Gehäuseoberteil 16 durchgängig befestigt werden kann.

Das Gehäuseoberteil 16 ist als eine transparente Folie (beispielsweise eine PE-Folie) ausgebildet, die so elastisch ist, dass eine gezielte Übertragung einer Betätigung des Gehäuseoberteils 16 auf den Touchscreen 2 möglich ist. Dadurch werden Betätigungen wie Tippen oder ein Darüberstreichen auf dem Gehäuseoberteil 16 durch den Touchscreen 2 erkannt, so dass der Touchscreen 2 des Bediengeräts 1 fehlerfrei bedient werden kann. Das Gehäuseoberteil 16 weist eine Größe und ein Material auf, die eine unlösbare Verbindung mit dem Gehäuseunterteil 15 ermöglichen. Im Gegensatz zum Gehäuseunterteil 15 ist das Gehäuseoberteil 16 hier zur Vereinfachung des Produktionsprozesses nicht als Formteil vorzusehen, sondern kann auf dem Gehäuseunterteil 15 als Flachmaterial zur weiteren Verarbeitung aufgebracht werden. Aus fertigungs- und produktionstechnischen Erwägungen ist es sinnvoll, das Gehäuseunterteil 15 und Gehäuseoberteil 16 aus dem gleichen Material, insbesondere auch mit der gleichen Wandstärke, vorzusehen. Für das Gehäuseunterteil 15 ergibt sich dann durch die Formgebung gegenüber dem Gehäuseoberteil 16 eine höhere Steifigkeit über die Geometrie.

Unter einer unlösbaren Verbindung wird eine Verbindung verstanden, die nur durch eine Zerstörung der Verbindung möglich ist. Die Verbindung wird beispielsweise durch Verschweißen oder Verkleben gebildet. Ein erneutes Erstellen einer zerstörten Verbindung ist ggf. möglich, sofern das Gehäuseunterteil 15 und das Gehäuseoberteil 16 beim Zerstören der Verbindung nicht beschädigt werden.

Durch die Ausbildung des Gehäuseunterteils 15 und des Gehäuseoberteils 16 und deren Verbindung ist das Schutzgehäuse flüssigkeitsdicht. Die Materialien des Gehäuseunterteils 15 und des Gehäuseoberteils 16 sind desinfektionsmittelbeständig, wodurch das Bediengerät 1 auch beispielsweise bei einer Wischdesinfektion geschützt ist.

Im Vergleich zu der lediglichen Verwendung einer Schutzfolie ist die Lebensdauer des Schutzgehäuses 14 wesentlich größer.

In dem Schutzgehäuse 14 sind optional ebenfalls die elektronischen Komponenten zum Orten, wie etwa der Funksender/-empfänger, und/oder zum kontaktlosen Aufladen des Akkumulators des Bediengeräts 1, wie etwa die Induktionsspule, vorgesehen.

Optional wird bei dem Verbinden des Gehäuseunterteils 15 und des Gehäuseoberteils 16 in dem Schutzgehäuse 14 ein Unterdruck erzeugt. Dieser Unterdruck ist so gewählt, dass er niedriger als ein weltweit bzw. an definierten Einsatzorten möglicher Luftdruck ist. Damit wird verhindert, dass unter jeglichen weltweiten Einsatzbedingungen, auch beispielsweise in Krankenhäusern in großen Höhen, verhindert wird, dass sich das Schutzgehäuse 14 aufwölbt.

Das Schutzgehäuse 14 wird wie folgend beschrieben hergestellt.

Das Gehäuseunterteil 15 wird ausgehend von dem plattenförmigen Ausgangsmaterial durch Vakuumtiefziehen in die dem Bediengerät 1 angepasste Form gebracht, so dass die Innenseite des Gehäuseunterteils 15 an die Bereiche von den Seiten und der Rückseite des Bediengeräts 1 angepasst ist. Hierbei wird auch die umlaufende Fläche zum durchgängigen Befestigen des Gehäuseoberteils 16 hergestellt. Alternativ sind auch andere Herstellungsverfahren, wie etwa Spritzgießen eines Kunststoffgranulats möglich.

Anschließend wird das Bediengerät 1 in das Gehäuseunterteil 15 eingebracht.

Optional werden die elektronischen Komponenten zum Orten und/ oder kontaktlosen Aufladen des Bediengeräts 1 in das Schutzgehäuse eingebracht.

Schließlich werden das Gehäuseoberteil 16 und das Gehäuseunterteil 15 zusammengeführt und an den Verbindungsstellen umfänglich flüssigkeitsdicht, insbesondere unlösbar, verbunden. Das unlösbare Verbinden erfolgt über Verkleben, Verschweißen oder einem anderen geeigneten Verfahren, z.B. Verbördeln.

Fig. 5 zeigt eine Querschnittsdarstellung des Schutzsystems aus dem Schutzgehäuse 14 und dem Stoßschutzrahmen 4. Der abnehmbare Stoßschutzrahmen 4 bietet einen zusätzlichen Schutz gegen Stöße, beispielsweise bei einem Herunterfallen des Bediengeräts 1 und verbessert eine Griffigkeit und Positionierbarkeit des Bediengeräts 1 auf einer Ladestation.

## Patentansprüche

1. Schutzsystem für ein Bediengerät (1) mit einem Touchscreen (2) für ein Medizingerät, aus
einem Stoßschutzrahmen (4) für das Bediengerät (1) mit dem Touchscreen (2) für das Medizingerät,
wobei der Stoßschutzrahmen (4) aus einem elastischen Material besteht, das sterilisierbar ist,
und der Stoßschutzrahmen (4) das Bediengerät (1) so umschließt, dass er auf einer Vorderseite und einer Rückseite des Bediengeräts (1) einen Überhang aufweist,
einer Schutzhülle (3) für das Bediengerät (1) mit dem Touchscreen (2) für das Medizingerät, die eine Aussparung (5) mit einer inneren Fläche (7) aufweist,
wobei die Schutzhülle (3) so geformt ist, dass sie das Bediengerät (1) umschließt, die innere Fläche (7) so geformt ist, dass sie im Wesentlichen an eine Rückseite des Bediengeräts (1) angepasst ist, und die Aussparung (5) eine Form und eine Größe hat, so dass zumindest eine Fläche des Touchscreens (2) ausgespart ist, und
wobei ein Rand (6) an der Aussparung (5) so geformt ist, dass der Rand (6) zwischen dem Bediengerät (1) und der Schutzhülle (3) einen flüssigkeitsdichten Übergang vorsieht,
und einer Folienhülle, wobei
der Stoßschutzrahmen (4) die Schutzhülle (3) so umschließt, dass er auf einer Vorderseite und einer Rückseite der Schutzhülle (3) einen Überhang aufweist,
die Folienhülle aus einem sterilisierbaren Material besteht, und eine Größe aufweist, so dass sie das Bediengerät (1) mit der Schutzhülle (3) umschließt und zwischen der Schutzhülle (3) und dem Stoßschutzrahmen (4) einbringbar ist, und
äußere Abmessungen der Schutzhülle (3) und Abmessungen einer inneren Kontur des Stoßschutzrahmens (4) so aufeinander abgestimmt sind, dass die Folienhülle dazwischen einklemmbar ist, um über dem Touchscreen (2) straff gehalten zu werden.

2. Schutzsystem gemäß Anspruch 1, wobei es elektronische Komponenten zum Orten und/oder zum kontaktlosen Aufladen eines Akkumulators des Bediengeräts (1) aufweist.

3. Schutzsystem (3) gemäß Anspruch 2, wobei es eine Induktionsspule (8) zum kontaktlosen Aufladen des Akkumulators aufweist.

## Claims

1. Protecting system for an operator device (1) having a touchscreen (2) for a medical apparatus of
a shock protective frame (4) for the operator device (1) having the touch screen (2) for the medical apparatus,
wherein the shock protective frame (4) is made of an elastic material which is sterilizable, and
the shock protective frame (4) encloses the operator device (1) such that it comprises an overhang at a front side and a rear side of the operator device (1),
a protective envelope (3), for the operator device (1) having the touchscreen (2) for the medical apparatus, comprising a recess (5) having an inner face (7),
wherein the protective envelope (3) is formed such that it encloses the operator device (1), the inner face (7) is formed such that it is substantially adapted to a rear side of the operator device (1), and the recess (5) has a shape and a size so that at least an area of the touchscreen (2) is left blank, and
wherein a rim (6) at the recess (5) is formed such that the rim (6) provides a liquid-tight transition between the operator device (1) and the protective envelope (3),
and a foil envelope, wherein
the shock protective frame (4) encloses the protective envelope (3) such that it comprises an overhang at a front side and a rear side of the protective envelope (3),
the foil envelope consists of a sterilizable material and has a size so that it encloses the operator device (1) with the protective envelope (3) and that it is insertable between the protective envelope (3) and the shock protective frame (4), and
outer dimensions of the protective envelope (3) and dimensions of an inner contour of the shock protective frame (4) are aligned to each other such that the foil envelope can be clamped there between in order to be maintained upon the touchscreen (2) in a close-fitting manner.

2. Protecting system according to claim 1, wherein it comprises electronic components for localizing and/or for contactless charging an accumulator battery of the operator device (1).

3. Protecting system according to claim 2, wherein it comprises an induction coil (8) for charging the accumulator battery in a contactless manner.

## Revendications

1. Système de protection d'un appareil de commande (1) comprenant un écran tactile (2) d'un appareil médical, comportant :
un cadre de protection antichocs (4) de l'appareil de commande (1) équipé de l'écran tactile (2) de l'appareil médical, ce cadre de protection antichocs (4) étant réalisé en un matériau élastique stérilisable, et entourant l'appareil de commande (1) de sorte qu'il présente un surplomb sur la face avant et sur la face arrière de l'appareil de commande (1),
une enveloppe de protection (3) de l'appareil de commande (1) équipé de l'écran tactile (2) de l'appareil médical qui comporte un évidement (5) ayant une surface interne (7),
l'enveloppe de protection (3) étant formée de sorte qu'elle entoure l'appareil de commande (1), la surface interne (7) étant formée de façon à être essentiellement adaptée à la face arrière de l'appareil de commande (1) et l'évidement (5) ayant une forme et une dimension telles qu'au moins une surface de l'écran tactile (2) soit dégagée,
un bord (6) de l'évidement (5) étant formé de sorte qu'il permette d'obtenir entre l'appareil de commande (1) et l'enveloppe de protection (3) une jonction étanche au liquide, et
un film enveloppe le cadre de protection antichocs (4) entourant l'enveloppe de protection (3) de sorte qu'il présente un surplomb sur la face avant et sur la face arrière de cette enveloppe de protection (3),
le film enveloppe étant réalisée en un matériau stérilisable et ayant une taille telle qu'il entoure l'appareil de commande (1) avec l'enveloppe de protection (3), et puisse être introduit entre l'enveloppe de protection (3) et le cadre de protection antichocs (4), et
les dimensions externes de l'enveloppe de protection (3) et les dimensions du contour interne du cadre de protection antichocs (4) étant adoptées de sorte que le film enveloppe puisse être bloquée entre ces éléments pour pouvoir être maintenu tendu sur l'écran tactile (2).

2. Système de protection conforme à la revendication 1, comportant des composants électroniques pour permettre de loger et/ou de charger sans contact un accumulateur de l'appareil de commande (1).

3. Système de protection (3) conforme à la revendication 2, comportant une bobine d'induction (8) pour permettre le chargement sans contact de l'accumulateur.
